# EUROPÄISCHE PATENTSCHRIFT

(11) **EP 1 123 455 B1**
(45) Veröffentlichungstag und Bekanntmachung des Hinweises auf die Patenterteilung: **17.09.2003**
(21) Anmeldenummer: 99953821.8
(22) Anmeldetag: 13.10.1999
(51) Int. Cl.: F01D 5/28, C23C 4/00, C23C 4/10, C23C 14/00

(54) **ERZEUGNIS MIT WÄRMEDÄMMSCHICHT SOWIE VERFAHREN ZUR HERSTELLUNG EINER WÄRMEDÄMMSCHICHT**
PRODUCT WITH A HEAT INSULATING LAYER AND METHOD FOR THE PRODUCTION OF A HEAT INSULATING LAYER
PRODUIT POURVU D'UNE COUCHE THERMO-ISOLANTE ET PROCEDE DE REALISATION D'UNE COUCHE THERMO-ISOLANTE

(30) Priorität: 22.10.1998 EP 98119791
(43) Veröffentlichungstag der Anmeldung: 16.08.2001
(73) Patentinhaber: SIEMENS AKTIENGESELLSCHAFT, 80333 München (DE)
(72) Erfinder: DÖPPER, Gebhard, D-74423 Obersontheim (DE)
(86) Internationale Anmeldenummer: EP9907733
(87) Internationale Veröffentlichungsnummer: WO00025005

(56) Entgegenhaltungen:
- EP-A- 0 139 396
- EP-A- 0 366 289
- WO-A-93/18199
- WO-A-96/31636
- US-A- 4 676 994
- US-A- 5 350 599

## Beschreibung

Die Erfindung betrifft ein Erzeugnis, insbesondere ein Bauteil einer Gasturbine, mit einem Grundkörper und einer darauf angeordneten Wärmedämmschicht. Die Erfindung betrifft weiter ein Verfahren zum Aufbringen einer Wärmedämmschicht auf ein Erzeugnis, welches einem heißen aggressiven Gas aussetzbar ist und einen Grundkörper, insbesondere einen metallischen Grundkörper aufweist.

Aus der US-PS 5,238,752 ist ein Wärmedämmschichtsystem mit einem intermetallischen Haftvermittlungsüberzug bekannt. Das Wärmedämmschichtsystem ist auf einem metallischen Grundkörper aufgebracht, insbesondere auf einem Cr-Co-Stahl für eine Flugtriebwerksschaufel. Unmittelbar auf diesem metallischen Grundkörper ist eine intermetallische Haftvermittlungsschicht, insbesondere aus einem Nickelaluminid oder einem Platinaluminid aufgebracht. An diese Haftvermittlungsschicht schließt sich eine dünne keramische Schicht aus Aluminiumoxid an, auf die die eigentliche Wärmedämmschicht, insbesondere aus mit Yttrium stabilisierten Zirkonoxid, aufgetragen ist. Diese keramische Wärmedämmschicht aus Zirkonoxid hat eine stabförmige Struktur, wobei die stabförmigen Stengel im wesentlichen senkrecht zur Oberfläche des Grundkörpers gerichtet sind. Hierdurch soll eine Verbesserung der zyklischen thermischen Belastungsfähigkeit gewährleistet sein. Die Wärmedämmschicht wird mittels eines Elektronenstrahl-PVD (Physical Vapour Deposition)-Verfahrens auf den Grundkörper abgeschieden, wobei mit einer Elektronenstrahlkanone aus einem metalloxidischen Körper Zirkonoxid verdampft wird. Das Verfahren wird in einer entsprechenden Vorrichtung durchgeführt, in der der Grundkörper auf eine Temperatur von etwa 950° C bis 1000° C vorgeheizt wird. Der Grundkörper wird während des Beschichtungsvorganges in dem Strahl aus Metalloxid mit einer konstanten Geschwindigkeit rotiert.

Ein Elektronenstrahl-PVD-Verfahren zur Herstellung eines keramischen Überzuges ist weiterhin in der US-PS 5,087,477 beschrieben, wobei hierin die keramische Schicht eine Schichtdicke zwischen 250 bis 375 µm aufweist.

In der US-PS 4,405,659 und der US-PS 5,514,482 sind jeweils Bauteile, insbesondere Gasturbinenschaufeln, aus einer Nikkel- oder Kobaltbasislegierung beschrieben, auf denen jeweils eine keramische Wärmedämmschicht mit stengelförmiger Struktur aufgebracht ist. Der mittlere Durchmesser der Stengel beträgt hierbei über 2,5 µm, wobei die Schichtdicke etwa 125 µm beträgt. Die keramische Wärmedämmschicht wird mittels eines EB(Electron Beam)-PVD-Verfahrens aufgebracht.

In der WO 98/13531 A1 ist ein Bauteil, insbesondere eine Gasturbinenschaufel, beschrieben welches auf einem metallischen Grundkörper eine keramische Wärmedämmschicht mit einer stengelförmigen Feinstruktur aufweist, wobei der mittlere Stengeldurchmesser unter 2,5 µm aufweist. Dieser geringe mittlere Stengeldurchmesser bei im Gasturbinenbau verwendeten Schichtdicken von größenordnungsmäßig über 100 µm wird durch ein reaktives Gasflußspatterverfahren erreicht. Hierbei wird ein ionisierbares Gas durch eine Hohlkathode geführt und aufgrund der in der Hohlkathode herrschenden Spannungen ionisiert, und somit zu der Innenwandung der Hohlkathode hin beschleunigt. Die Hohlkathode weist an ihrer Innenwandung das Beschichtungsmaterial, insbesondere metallisches Zirkon auf, welches durch die Ionen herausgeschlagen und in Richtung des zu beschichtenden Grundkörpers transportiert wird.

Aus der US 5,350,599 ist eine Wärmedämmschicht für eine Turbinenschaufel bekannt, die mehrere übereinander liegende Schichten aufweist. Die äußere Oberflächenschicht ist dabei erosionsresistent ausgebildet, während die darunter liegende Schicht porös ausgebildet ist. Beide Schichten sind aus keramischem Material und werden aufeinanderfolgend mittels des PVD-Verfahrens aufgebracht. Durch Variation der Prozessparameter beim Beschichten wird die poröse bzw. die dichte Struktur der erosionsresistenten äußeren Schicht erhalten. Durch das Aufbringen der äußeren erosionsresistenten Schicht soll die Turbinenschaufel vor Erosionsschäden geschützt werden.

Aus der EP 0 139 396 A1 ist ein Beschichtungssystem für eine Turbinenschaufel bekannt, bei der in unterschiedlichen Oberflächenbereichen verschiedene Beschichtungen aufgebracht sind, und zwar in Abhängigkeit der an der Turbinenschaufel auftretenden Temperatur. Hierbei wird zwischen einem heißen und einem kalten Ende der Turbinenschaufel unterschieden. Die verschiedenen Beschichtungen sind dabei auf die unterschiedlichen Temperaturanforderungen hinsichtlich ihrer Duktilität und ihres Kriechverhaltens besonders angepasst. Sie weisen hierzu unterschiedliche chemische Zusammensetzungen auf. Dies macht erforderlich, dass zwischen benachbarten Schichten unterschiedlicher Zusammensetzung eine Übergangsschicht angeordnet wird.

Aufgabe der Erfindung ist es, ein Erzeugnis, welches einem heißen aggressiven Gas aussetzbar ist, mit einer beanspruchungsgerechten Wärmedämmschicht anzugeben. Eine weitere Aufgabe der Erfindung liegt darin ein Verfahren zur Beschichtung eines Erzeugnisses mit einer Wärmedämmschicht anzugeben.

Erfindungsgemäß wird die erstgenannte Aufgabe durch ein Erzeugnis, insbesondere ein Bauteil einer Gasturbine, welches einem heißen aggressiven Gas aussetzbar ist und einen Grundkörper aufweist, gelöst, wobei auf dem Grundkörper eine Wärmedämmschicht gleicher chemischer Zusammensetzung aufgebracht ist, die in einem ersten Oberflächenbereich und in einem zweiten Oberflächenbereich unterschiedliche Feinstrukturen aufweist, und somit entsprechend den jeweils beim bestimmungsgemäßen Einsatz lokal herrschenden oder zu erwartenden thermomechanischen Beanspruchungen des Erzeugnisses beanspruchungsgerecht ausgebildet ist. Die beiden Oberflächenbereiche liegen in der gleichen Oberflächenebene oder Oberflächenschicht. Sie sind insbesondere nebeneinander angeordnet. Die Wärmedämmschicht weist in den Oberflächenbereichen ein hinsichtlich seiner chemischen Zusammensetzung gleiches Wärmedämmmaterial auf. Die Wärmedämmschicht kann also als eine Ein-Material Dämmschicht bezeichnet werden. Dies hat gegenüber Mehr-Material Dämmschichten den entscheidenden Vorteil, dass die einem Materialübergang inhärenten Probleme vermieden sind. Zugleich sind durch die unterschiedlichen Feinstrukturen die jeweiligen Oberflächenbereiche für die zu erwartenden Belastungen ausgelegt.

Es ist hierbei ebenfalls zusätzlich oder alternativ möglich, daß in zwar geometrisch unterschiedlich ausgebildeten Bereichen, insbesondere hinsichtlich Oberflächenkrümmung, Konvexität oder Konkavität, bei einer zu erwartenden gleichen lokalen thermomechanischen Belastung die Feinstruktur in den geometrisch unterschiedlichen Oberflächenbereichen im wesentlichen gleich ausgeführt ist. Diese spezielle Ausbildung der Beschichtung ist von Vorteil, insbesondere bei gekrümmten Bauteilen, die einem heißen Gasstrom ausgesetzt sind, welcher zu lokal unterschiedlichen thermomechanischen Belastungen führt, da die Wärmedämmschicht lokal an die auftretenden thermomechanischen Belastungen, wie Temperatur und Krafteinwirkungen durch auftreffende Partikel, angepasst ist. Hierdurch läßt sich gezielt die Lebensdauer der Wärmedämmschicht lokal beeinflussen, insbesondere verlängern, so daß auch die Einsatzdauer und die Lebensdauer des Erzeugnisses verlängert wird.

Vorzugsweise weist die Wärmedämmschicht eine Feinstruktur mit Keramikstengeln auf, welche im wesentlichen normal zur Oberfläche des Grundkörpers gerichtet sind. Die Keramikstengel können hierbei einen Durchmesser von einigen µm bei einer Schichtdicke von bis zu 100 µm oder mehr aufweisen. Eine Feinstruktur mit Keramikstengeln ist insbesondere vorteilhaft, da diese Wärmedehnungen des Grundkörpers vor allem bei zyklischen Temperaturwechseln ohne Beschädigung folgen kann.

Die Keramikstengel im ersten Oberflächenbereich weisen vorzugsweise einen geringeren mittleren Durchmesser als im zweiten Oberflächenbereich auf. Die Wärmedämmschicht im ersten Oberflächenbereich kann mithin allgemein eine feinere Feinstruktur als im zweiten Oberflächenbereich besitzen, wodurch insbesondere dieser Bereich mit feinerer Feinstruktur erhöhten Temperaturen, insbesondere Temperaturwechselbeanspruchungen standhalten kann. Die Wärmedämmschicht im ersten Oberflächenbereich, welcher einer höheren thermomechanischen Belastung als der zweite Oberflächenbereich ausgesetzt ist, weist gegenüber der Wärmedämmschicht im zweiten Oberflächenbereich vorzugsweise eine dichtere Feinstruktur auf.

Das Erzeugnis ist vorzugsweise ein Bauteil einer thermischen Maschine, insbesondere einer Gasturbine, wie einer stationären Gasturbine mit dem Einsatzgebiet in der Kraftwerkstechnik oder einer Flugtriebwerksturbine. Das Erzeugnis kann hierbei als ein Hitzeschild einer Brennkammer oder als eine Turbinenschaufel, eine Turbinenlaufschaufel oder Turbinenleitschaufel, ausgebildet sein. Eine Turbinenschaufel weist eine Anströmkante und eine Abströmkante auf, mit dazwischen sich gegenüberliegend angeordneter Druckseite und Saugseite. Die Anströmkante ist die thermisch höchstbelastete Stelle einer Turbinenschaufel und zudem aufgrund des dort auftreffenden Heißgases auch erhöhten Erosionsbedingungen ausgesetzt. An der Saugseite und der Druckseite herrschen lokal ähnliche thermomechanische Beanspruchungen. Vorzugsweise weist mithin eine Turbinenschaufel an der Saugseite und der Druckseite eine jeweilige Wärmedämmschicht mit im wesentlichen gleicher Feinstruktur (zweiter Oberflächenbereich) auf. An der Anströmkante ist vorzugsweise eine feinere Feinstruktur der Wärmedämmschicht (erster Oberflächenbereich) vorgesehen, so daß diese den dort herrschenden thermomechanischen Beanspruchungen gerecht wird. Ein solche Wärmedämmschicht ist gegenüber den thermomechanischen Belastungen resistenter als die Wärmedämmschicht an Saugseite und Druckseite.

Die Wärmedämmschicht ist vorzugsweise keramisch. Sie kann Zirkonoxid (ZrO₂) oder ein anderes für den Einsatz bei hohen Temperaturen geeignetes keramisches Material, insbesondere ein Metalloxid, aufweisen. Ein Zirkonoxid ist vorzugsweise mit Yttriumoxid (Y₂O₃) oder mit einem anderen Oxid eines Elementes der Seltenen Erden teil- oder vollstabilisiert. Alternativ kann die Wärmedämmschicht auch eine Verbindung aus der Gruppe der refraktären Perowskite, z.B. LaAlO₃, CaZrO₃, oder der Spinelle umfassen, z.B. MgAl₂O₄, MgCr₂O₄ oder AB₂O₄, wobei A für ein Element der Gruppe Ni, Co, Ti; B für A1 oder Cr und O für Sauerstoff steht.

Der Grundkörper ist vorzugsweise metallisch ausgeführt. Für Anwendungen bei hohen Temperaturen mit entsprechenden Anforderungen an Korrosionsbeständigkeit eignen sich besonders Nickel- und/oder Kobaltbasislegierungen, wie sie beispielhaft unter anderem in der US-PS 4,405,659 angegeben sind.

Zwischen Grundkörper und Wärmedämmschicht ist vorzugsweise eine Haftvermittlerschicht angeordnet. Diese kann aus einer Legierung umfassend Chrom, Aluminium, Yttrium und/oder eines der Elemente der Gruppe IIIb des Periodensystems einschließlich der Actiniden und der Lanthaniden sowie zusätzlich oder alternativ Rhenium enthalten, wobei der überwiegende Rest der Legierung aus Eisen, Kobalt und/oder Nickel bestehen kann. Solche Yttrium aufweisenden Legierungen sind in der Literatur unter der Bezeichung "MCrAlY"-Legierung zu finden. Legierungen die gegenüber dem Anteil an Yttrium deutlich mehr Rhenium enthalten können als "MCrAlRe"-Legierung bezeichnet werden. Zwischen der Haftvermittlerschicht und der Wärmedämmschicht kann eine Oxidschicht, insbesondere aus Aluminiumoxid, Chromoxid und/oder Galliumoxid vorgesehen sein. Eine solche Oxidschicht kann bereits als Oxid aufgebracht sein oder infolge Oxidation (Thermaly Grown Oxid, TGO) thermisch bedingt entstehen.

Die auf ein Verfahren zum Aufbringen einer Wärmedämmschicht auf ein Erzeugnis, welches einem heißen aggressiven Gas aussetzbar ist und einen Grundkörper aufweist, gerichtete Aufgabe wird erfindungsgemäß dadurch gelöst, daß auf den Grundkörper eine Wärmedämmschicht einheitlicher chemischer Zusammensetzung derart aufgebracht wird, daß die Wärmedämmschicht sich in einem ersten Oberflächenbereich des Grundkörpers mit einer ersten Feinstruktur und in einem zweiten Oberflächenbereich mit einer zweiten Feinstruktur entsprechend der bei Einsatz des Erzeugnisses lokal zu erwartenden thermomechanischen Belastung ausbildet.

Mit dem Verfahren wird mithin ein Erzeugnis bereitgestellt, welches eine den lokalen an dem Erzeugnis auftretenden thermomechanischen Belastungen Rechnung trägt. Insbesondere kann dadurch die Wärmedämmschicht an einem hochbelasteten Bereich (ersten Oberflächenbereich) resistenter als in einem zweiten Oberflächenbereich, der geringer thermomechanisch belastet ist, ausgebildet sein. Es ist hierdurch ebenfalls möglich, gezielt in lokalen Oberflächenbereichen, welche im wesentlichen gleichen thermomechanischen Bedingungen ausgesetzt sind, auch eine jeweilige Wärmedämmschicht mit im wesentlichen gleicher Feinstruktur herzustellen. Dies ist insbesondere dann vorteilhaft, wenn die geometrische Ausgestaltung solcher zweiten Oberflächenbereich unterschiedlich ist, insbesondere sich die Krümmungen in Größe und/oder Richtung (konkav, konvex) deutlich voneinander unterscheiden.

Vorzugsweise wird das Verfahren zur Herstellung einer Wärmedämmschicht als Elektronenstrahl-Bedampfungsverfahren (Electron-Beam-Physical-Vapour Deposition; EB-PVD) oder als reaktives Gasfluß-Sputterverfahren, wie es beispielsweise in der WO 98/13531 A1 beschrieben ist, durchgeführt. Bei den physikalischen Abscheidungsverfahren einer Wärmedämmschicht aus einer Dampfphase (Physical-Vapour Deposition) wird der Beschichtungsprozeß durch verschiedene Prozeßparameter, wie Temperatur des zu beschichtenden Erzeugnisses, Leistung einer Elektronenstrahlkanone, Beschleunigung der abzuscheidenden Teilchen in Richtung des Erzeugnisses, Gasfluß in einer Beschichtungskammer, Zufuhr von Sauerstoff, Partialdruck eines Reaktivgases, Gesamtdruck in der Beschichtungskammer, Heizleistung einer Beheizungsvorrichtung, Rotationsgeschwindigkeit des Erzeugnisses, Relativbewegung zwischen Erzeugnis und einem die Wärmedämmschicht bildenden Teilstrahl, und anderen Prozeßparametern bestimmt. Bei dem Verfahren werden entsprechend der lokalen Anforderung der Wärmedämmschichten einzelne oder mehrere Prozeßparameter so gesteuert oder geregelt, daß sich die Wärmedämmschicht entsprechend der lokalen Anforderungen bildet.

Das Verfahren wird vorzugsweise auf eine Schaufel einer Strömungsmaschine, insbesondere einer Gasturbine angewandt, wobei die Wärmedämmschicht auf der Saugseite im wesentlichen die gleiche Feinstruktur wie auf der Druckseite aufweisen kann. Bei einer Schaufel ist es zusätzlich oder alternativ auch möglich, an einer Anströmkante, welche einer erhöhten thermomechanischen Belastung, insbesondere einem Erosionsangriff, ausgesetzt ist, die Wärmedämmschicht resistenter, insbesondere mit einer feineren Feinstruktur aufzubringen als an weniger stark belasteten Oberflächenbereichen. Weniger stark belastete Oberflächenbereiche können hierbei die Saugseite, die Druckseite oder die Abströmkante der Schaufel sein. Hierbei können die Prozeßparameter, wie beispielsweise die Bewegung des Erzeugnisses (der Turbinenschaufel), die als einfache Rotation des Erzeugnisses um eine Achse sowie als schwenkende und/oder neigungsverändernde Bewegung ausgestaltet sein kann, die lokale Schichtrate auf der einem Teilchenverdampfungstiegel zugewandten Oberfläche des Erzeugnisses sowie weitere Prozeßparameter so aufeinander abgestimmt werden, daß die lokal gewünschte, beanspruchungsgerechte Schichtstruktur erzeugt wird. Parameter die sich hierbei beeinflussen können, sind unter anderem die Schichtrate, die Leistung einer Verdampferkanone bei EB-PVD-Verfahren, die Ablenkung der Verdampferkanonen-Elektronenstrahlen, der Gesamtdruck in der Beschichtungskammer, der Partialdruck eines Reaktivgases, die Temperatur des Erzeugnisses, die Art der Bewegung, die Relativgeschwindigkeit des Erzeugnisses während der Bedampfung.

Bei einer Turbinenschaufel läßt sich beispielsweise eine beanspruchungsgerechte Wärmedämmschicht durch eine Verknüpfung der Verdampfungsleistung mit der Rotation der Turbinenschaufel herstellen. Hierbei kann zu dem Zeitpunkt, an dem die Anströmkante der Schaufel dem Verdampfungstiegel zugewandt ist, die Rotationsgeschwindigkeit bei gesenkter Verdampfungsleistung erhöht werden, so daß lokal die Schichtrate sinkt und zugleich eine dichte Schichtstruktur realisiert wird. Weist beispielsweise die Druckseite der Schaufel zum Verdampfungstiegel, so kann die Rotationsgeschwindigkeit reduziert und die Verdampfungsleistung gesteigert werden, so daß die Schichtstruktur der Wärmedämmschicht weniger dicht ausfällt, und daß durch gleichzeitig entsprechende Anpassung des Prozesses für die Saugseite die Wärmedämmschicht an der Saugseite und an der Druckseite eine im wesentlichen gleichen Feinstruktur aufweist.

Ein Erzeugnis mit Wärmedämmschicht sowie ein Verfahren zur Aufbringung einer Wärmedämmschicht werden nachfolgend beispielhaft anhand eines Ausführungsbeispieles erläutert. Es zeigen teilweise schematisiert und nicht maßstabsgerecht
- FIG 1: eine Turbinenlaufschaufel
- FIG 2: einen Querschnitt durch eine Turbinenschaufel
- FIG 3 u. FIG 4: einen Schnitt durch ein Wärmedämmschichtsystem der Turbinenschaufel gemäß FIG 2 und
- FIG 5: eine Beschichtungsanlage zur Beschichtung einer Turbinenschaufel mit einer Wärmedämmschicht.

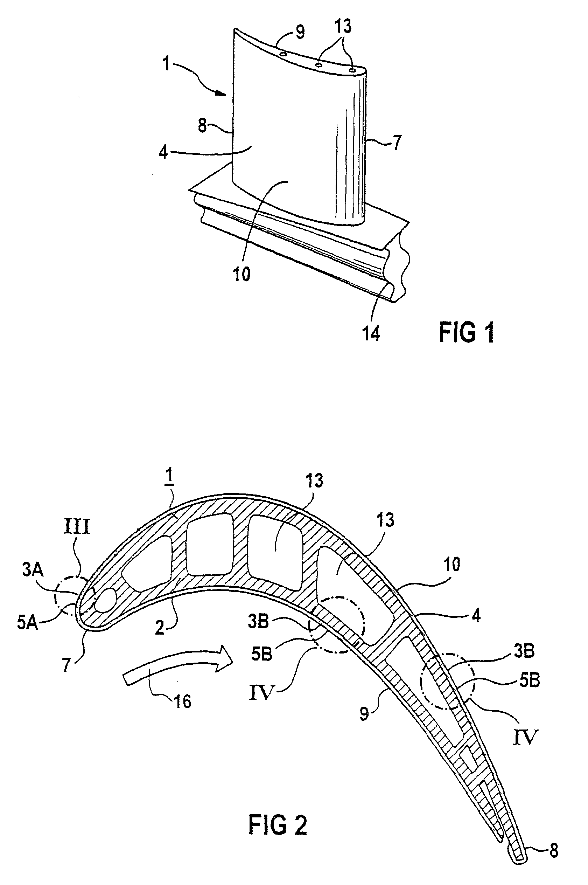

In der FIG 1 ist in einer perspektivischen Ansicht als Erzeugnis eine Turbinenschaufel 1, insbesondere eine Laufschaufel einer Gasturbine, dargestellt, die einen Schaufelfuß 14 aufweist, mit dem die Turbinenschaufel 1 in eine nicht dargestellte drehbare Welle befestigt werden kann. An den Schaufelfuß 14 schließt sich der eigentliche Schaufelblattbereich an, welcher sich von einer Anströmkante 7 zu einer Abströmkante 8 über einerseits eine Druckseite 9 und andererseits eine Saugseite 10 erstreckt. In dem eigentlichen Schaufelblattbereich sind Kühlkanäle 13 zur Führung eines Kühlmediums, insbesondere Kühlluft, vorgesehen. Der Schaufelblattbereich bildet eine gesamte Oberfläche 4 mit unterschiedlich gekrümmten Oberflächenbereichen.

In FIG 2 ist in einem Querschnitt als Erzeugnis die Turbinenschaufel 1 einer Gasturbine dargestellt, die während eines Einsatzes in einer nicht gezeigten Gasturbine von einem Heißgas 16 umströmt wird. Im Querschnitt erstreckt sich die Turbinenschaufel 1 von der Anströmkante 7 über die Druckseite 9 und die Saugseite 10 zu einer Abströmkante 8. Die Turbinenschaufel 1 ist aus einem Grundkörper 2 gebildet, in dessen Inneren mehrere Kühlkanäle 13 zur Führung von Kühlluft vorgesehen sind. Die gesamte Oberfläche 4 der Turbinenschaufel 1 ist mit einer Wärmedämmschicht 5A, 5B beschichtet. Im Bereich der Anströmkante 7 (erster Oberflächenbereich 3A) ist einer erste Wärmedämmschicht 5A vorgesehen, die besonders resistent zum Schutze der Turbinenschaufel 1 gegen eine Anströmung mit dem Heißgas 16 ist, welches neben einer hohen thermischen Belastung der Anströmkante 7 auch zu einem Erosionsangriff führen kann. An der Druckseite 9, die eine andere Krümmung als die Anströmkante 7 aufweist und auch eine geringere thermomechanische Belastung erfährt, ist in einem zweiten Oberflächenbereich 3B, welcher sich im wesentlichen über die gesamte Oberfläche der Druckseite 9 erstrecken kann, eine zweite Wärmedämmschicht 5B aufgebracht. Diese zweite Wärmedämmschicht 5B ist vorzugsweise gegenüber der ersten Wärmedämmschicht 5A aufgrund der dort herrschenden geringeren thermomechanischen Belastung weniger dicht ausgeführt. Analog ist eine Wärmedämmschicht 5B in einem zweiten Oberflächenbereich 3B an der Saugseite 10 vorgesehen, die mit ihrer Feinstruktur im wesentlichen der Wärmedämmschicht 5B an der Druckseite 9 entspricht.

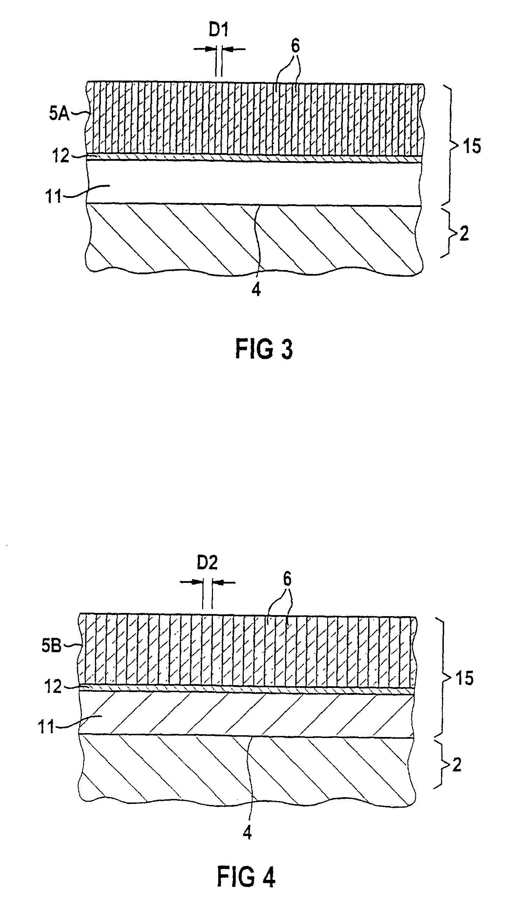

In den Figuren 3 und 4 ist schematisch der Aufbau eines Wärmedämmschichtsystems 15 an der Anströmkante 7 (FIG 3) und der Saugseite 10 bzw. Druckseite 9 (FIG 4) dargestellt. Das Wärmedämmschichtsystem 15 ist auf den Grundkörper 2 aufgebracht und weist unmittelbar an den Grundkörper 2 angrenzend eine Haftvermittlerschicht bzw. Oxidations- und Korrosionsschutzschicht 11, daran angrenzend eine Oxidschicht 12 und auf der Oxidschicht 12 die eigentliche Wärmedämmschicht 5A, 5B auf. Die Haftvermittlerschicht 11 kann eine Legierung der Art MCrAlY oder MCrAlRe sein. Die Oxidschicht 12 kann im wesentlichen aus einem Aluminiumoxid bestehen oder alternativ oder zusätzlich weitere Metalloxide wie Chromoxid oder Galliumoxid aufweisen. Die Wahl der Haftvermittlerschicht 11 sowie der Oxidschicht 12 richtet sich selbstverständlich nach dem Material des Grundkörpers 2 sowie der aufzubringenden Wärmedämmschicht 5A, 5B, die beispielsweise aus teilstabilisiertem Zirkonoxid bestehen kann. Die Wärmedämmschicht 5A, 5B weist eine Feinstruktur mit Keramikstengeln 6 auf, die im wesentlichen senkrecht zur Oberfläche 4 des Grundkörpers 2 orientiert sind. Die Keramikstengel 6 weisen jeweils einen mittleren Stengeldurchmesser D1, D2 auf. Der Stengeldurchmesser D1 der Keramikstengel 6 im Bereich der Anströmkante 7 ist geringer als der Stengeldurchmesser D2 im Bereich der Saugseite 10 bzw. der Druckseite 9. Hierdurch ist die Wärmedämmschicht 5A an der Anströmkante 7 nicht nur dichter sondern auch besser geeignet, thermomechanische Wechselbeanspruchungen ohne Beschädigung zu überstehen. Der Stengeldurchmesser D1 kann hier bei einer Schichtdicke der Wärmedämmsicht 5A von etwa 100 um bis 200 µm im Bereich zwischen 0,5 und 5 µm, vorzugsweise unterhalb 2,5 µm, liegen.

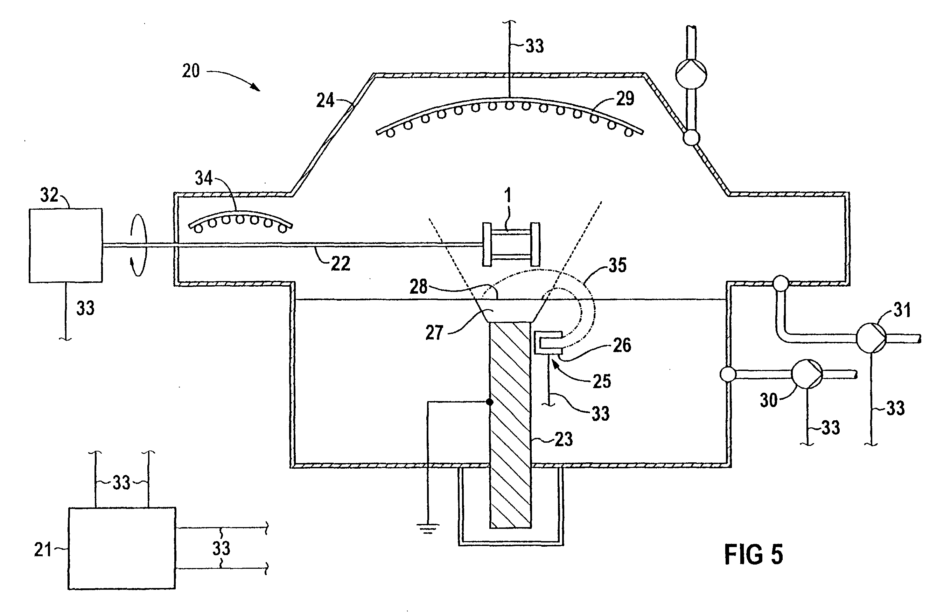

In FIG 5 ist in einem schematischen Längsschnitt eine Beschichtungsvorrichtung 20 zum Aufbringen einer Wärmedämmschicht 5A, 5B auf ein Erzeugnis 1, insbesondere eine Gasturbinenschaufel, dargestellt. Die Beschichtungsvorrichtung 20 weist eine Beschichtungskammer 24 auf, in der ein geeigneter Unterdruck (Vakuum) einstellbar ist. Zur Erzeugung des Unterdruckes sind beispielhaft zwei Pumpen, nämlich eine mechanische Pumpe 30 und eine Diffusionspumpe 31 angegeben. Jede dieser Pumpen 30, 31 ist über eine Verbindungsleitung 33 mit einer Steuereinrichtung 21 verbunden, durch die sich die Pumpleistung und damit der Vakuumdruck in der Beschichtungskammer 24 einstellen lassen. In einem unteren Bereich weist die Beschichtungskammer 24 ein stabförmiges Beschichtungs-Target 23 aus dem die Wärmedämmschicht bildenden Material, beispielsweise Zirkon, auf. Dieses Beschichtungs-Target 23 ist geerdet. Oberhalb des Beschichtungs-Targets 23 ist die zu beschichtende Turbinenschaufel 1 mit einem rotierbaren Bauteilhalter 22 gehaltert, welcher außerhalb der Beschichtungskammer 24 mit einem Antriebsmotor 32 verbunden ist. Dieser Antriebsmotor 32 dient der Rotation der Turbinenschaufel 1 um die nicht dargestellte Längsachse der Turbinenschaufel 1, so daß die Turbinenschaufel 1 allseitig beschichtet wird. Der Antriebsmotor 32 ist ebenfalls über eine Verbindungsleitung 33 mit der Steuereinrichtung 21 verbunden. An der der Turbinenschaufel 1 zugewandten Oberfläche 28 des Beschichtungs-Targets 23 ist ein in Richtung der Turbinenschaufel 1 sich öffnender Schmelztopf 27 (Verdampfungstiegel) angeordnet. Innerhalb der Beschichtungskammer 24 ist eine Elektronenstrahlkanone 25 angeordnet, welche so mit Umlenkplatten 26 versehen ist, daß ein Elektronenstrahl 35 in den Verdampfungstiegel 27 trifft. Es versteht sich, daß die Elektronenstrahlkanone 25 auch an einer anderen Stelle - gegebenenfalls außerhalb der Beschichtungskammer 24 - angeordnet sein kann. Die Elektronenstrahlkanone 25 ist ebenfalls über eine Verbindungsleitung 33 mit der Steuereinrichtung 21 verbunden. Oberhalb der Turbinenschaufel 1 ist eine Schaufelheizung 29 angeordnet, die ebenfalls über eine Verbindungsleitung 33 mit der Steuereinrichtung 21 verbunden ist. Weiterhin ist in der Beschichtungskammer 24 eine Vorheizung 34 vorgesehen, durch die vor Beginn der eigentlichen Beschichtung eine Aufheizung der Turbinenschaufel 1 auf eine vorgegebene Temperatur erreichbar ist.

Während des Beschichtungsvorganges (EB-PVD-Verfahren) ist die Turbinenschaufel 1 zwischen der Schaufelheizung 29 und dem Verdampfungstiegel 27 angeordnet. Ein von der Elektronenstrahlkanone 25 austretender Elektronenstrahl 35 bringt das Beschichtungsmaterial 23 in dem Verdamfpungstiegel 27 zum Schmelzen (zum Verdampfen). Aus dem Verdampfungstiegel 27 tritt das Beschichtungsmaterial in Richtung der Turbinenschaufel 1 aus und scheidet sich auf dieser als Wärmedämmschicht 5A, 5B ab. Das Beschichtungsmaterial kann hierbei bereits in der chemischen Zusammensetzung vorliegen, wie es in der Wärmedämmschicht 5A, 5B vorliegen soll, insbesondere bereits als Oxid, beispielsweise Zirkonoxid. Es ist ebenfalls möglich, im Rahmen eines reaktiven Gasfluß-Sputterverfahrens ein metallisches Beschichtungsmaterial zu verdampfen, welches nach Abscheidung auf der Turbinenschaufel 1 durch Sauerstoff oxidiert wird oder auf dem Weg zur Turbinenschaufel 1 bereits zu dem gewünschten Metalloxid oxidiert wird.

Durch die Steuereinrichtung 21 werden die Prozeßparameter des Beschichtungsvorganges so gesteuert oder geregelt, daß entsprechend den lokalen Anforderungen an die Wärmedämmschicht 5A, 5B eine entsprechende Abscheidung unter Bildung der Wärmedämmschicht 5A, 5B in den unterschiedlichen Oberflächenbereichen 3A, 3B der Turbinenschaufel 1 entsteht. Beispielsweise kann die Verdampfungsleistung mit der Bauteilrotation so verknüpft sein, daß zum Zeitpunkt, an dem die Anströmkante 7 der Turbinenschaufel 1 zum Verdampfungstiegel 27 weist, die Rotationsgeschwindigkeit über den Antriebsmotor 32 bei gesenkter Verdampfungsleistung (Leistung der Elektronenstrahlkanone 25) erhöht werden, so daß lokal die Schichtrate sinkt und zugleich eine dichte Schichtstruktur der Wärmedämmschicht 5A realisiert wird. Liegen die Druckseite 10 der Turbinenschaufel 1 oder die Saugseite 9 der Turbinenschaufel 1 dem Verdampfungstiegel 27 gegenüber, so kann die Rotationsgeschwindigkeit reduziert und die Verdampfungsleistung gesteigert werden, wodurch eine weniger dichte Wärmedämmschicht erreichbar ist.

## Patentansprüche

1. Erzeugnis (1), welches einem heißen aggressiven Gas (16) aussetzbar ist, mit einem Grundkörper (2), auf den eine Wärmedämmschicht (5A, 5B) einheitlicher chemischer Zusammensetzung aufgebracht ist, die in einem ersten Oberflächenbereich (3A) eine andere Feinstruktur als in einem zweiten Oberflächenbereich (3B) aufweist.

2. Erzeugnis (1) nach Anspruch 1, bei dem die Wärmedämmschicht (5A, 5B) eine Feinstruktur mit Keramikstengeln (6) aufweist, welche im wesentlichen normal zur Oberfläche (4) des Grundkörpers (2) gerichtet sind.

3. Erzeugnis (1) nach Anspruch 2, bei dem die Keramikstengel (6) im ersten Oberflächenbereich (3A) einen geringeren mittleren Durchmesser (D1) als im einem zweiten Oberflächenbereich (3B) aufweisen.

4. Erzeugnis (1) nach einem der Ansprüche 1 bis 3, bei dem die Wärmedämmschicht (5A) im ersten Oberflächenbereich (3A) eine feinere Feinstruktur als im zweiten Oberflächenbereich (3B) aufweist.

5. Erzeugnis (1) nach einem der vorhergehenden Ansprüche, bei dem die Wärmedämmschicht (5A) im ersten Oberflächenbereich (3A) eine dichtere Feinstruktur als im zweiten Oberflächenbereich (3B) aufweist.

6. Erzeugnis (1) nach einem der vorhergehenden Ansprüche, welches als Bauteil einer thermischen Maschine, insbesondere einer Gasturbine, ausgestaltet ist.

7. Erzeugnis (1) nach Anspruch 6, welches als Hitzeschild einer Brennkammer ausgestaltet ist.

8. Erzeugnis (1) nach Anspruch 6, welches als Turbinenschaufel ausgebildet ist.

9. Erzeugnis (1) nach Anspruch 8, welches sich im Querschnitt von einer Anströmkante (7) zu einer Abströmkante (8) erstreckt, und dazwischen sich gegenüberliegend eine Druckseite (9) und eine Saugseite (10) aufweist, wobei die Wärmedämmschicht (5B) an der Saugseite (10) und der Druckseite (9) im wesentlichen die gleiche Feinstruktur und an der Anströmkante (7) eine feinere Feinstruktur aufweist.

10. Erzeugnis (1) nach einem der vorhergehenden Ansprüche, bei dem die Wärmedämmschicht (5A,5B) Zirkonoxid (ZrO₂) oder eine Verbindung aus der Gruppe der refraktären Perowskite oder der Spinelle aufweist.

11. Erzeugnis (1) nach Anspruch 10, bei dem die Wärmedämmschicht (5A,5B) mit Yttriumoxid (Y₂O₃) oder einem anderen Oxid der seltenen Erden teil- oder vollstabilisiert ist.

12. Erzeugnis (1) nach einem der vorhergehenden Ansprüche, welches einen metallischen Grundkörper (2) aufweist, insbesondere aus einer Nickel- und/oder Kobaltbasislegierung.

13. Erzeugnis (1 nach einem der vorhergehenden Ansprüche, wobei zwischen Grundkörper (2) und Wärmedämmschicht (5A,5B) eine Haftvermittlerschicht (11) angeordnet ist, insbesondere aus einer Legierung der Art MCrAlY ist, wobei Cr für Chrom, A1 für Aluminium, M für ein Element oder mehrere Elemente aus der Gruppe umfassend Eisen, Kobalt und Nickel, sowie Y für ein Element oder mehrere Elemente der Gruppe IIIb des Periodensystems einschließlich der Actiniden und der Lanthaniden sowie Rhenium steht.

14. Verfahren zum Aufbringen einer Wärmedämmschicht (5A,5B) auf ein Erzeugnis (1), welches einem heißen aggressiven Gas (16) aussetzbar ist und einen Grundkörper (2) aufweist, auf den eine Wärmedämmschicht (5A,5B) einheitlicher chemischer Zusammensetzung derart aufgebracht wird, dass sich in einem ersten Oberflächenbereich (3A) die Wärmedämmschicht (5A) mit einer ersten Feinstruktur und in einem zweiten Oberflächenbereich (3B) die Wärmedämmschicht (5B) mit einer zweiten Feinstruktur entsprechend der bei Einsatz des Erzeugnisses (1) lokal zu erwartenden thermomechanischen Belastung ausbildet.

15. Verfahren nach Anspruch 14, bei dem als Erzeugnis (1) eine Schaufel einer Strömungsmaschine mit einer Saugseite (10) und einer Druckseite (9) verwendet wird, wobei die Wärmedämmschicht (5B) auf der Saugseite (10) die gleiche Feinstruktur wie auf der Druckseite (9) aufweist.

16. Verfahren nach Anspruch 14 oder 15, bei dem als Erzeugnis (I) eine Schaufel einer Strömungsmaschine mit einer Anströmkante (7) und sich daran anschließender Saugseite (10) und Druckseite (9) verwendet wird, wobei auf die Anströmkante (7) eine Wärmedämmschicht (5A) mit einer feineren Feinstruktur als eine Wärmedämmschicht (5B) auf der Saugseite (10) und/oder Druckseite (9) aufgebracht wird.

17. Verfahren nach Anspruch 14 bis 16, welches als Elektronenstrahl-Sputterverfahren (EB-PVD) oder reaktives Gasfluß-Sputterverfahren durchgeführt wird.

18. Verfahren nach Anspruch 17, bei dem Prozeßparameter, wie Relativbewegung zwischen Erzeugnis (1) und einem die Wärmedämmschicht (5A/5B) bildenden Teilchenstrahl (35), Schichtrate, Gesamtdruck in einer Beschichtungskammer, Partialdruck eines Reaktivgases, Temperatur des Erzeugnisses (1), entsprechend der zu erzielenden Feinstruktur der Wärmedämmschichten (5A,5B) gesteuert werden.

## Claims

1. Product (1) which can be exposed to a hot aggressive gas (16), having a base body (2) to which a thermal barrier coating (5A, 5B) of uniform chemical composition is applied, which coating, in a first surface region (3A), has a fine structure different from in a second surface region (3B).

2. Product (1) according to Claim 1, in which the thermal barrier coating (5A, 5B) has a fine structure with ceramic columns (6) which are oriented substantially perpendicular to the surface (4) of the base body (2).

3. Product (1) according to Claim 2, in which the ceramic columns (6) in the first surface region (3A) have a smaller mean diameter (D1) than in the second surface region (3B).

4. Product (1) according to one of Claims 1 to 3, in which the thermal barrier coating (5A) in the first surface region (3A) has a finer fine structure than in the second surface region (3B).

5. Product (1) according to one of the preceding claims, in which the thermal barrier coating (5A) in the first surface region (3A) has a denser fine structure than in the second surface region (3B).

6. Product (1) according to one of the preceding claims, which is designed as a component of a thermal machine, in particular of a gas turbine.

7. Product (1) according to Claim 6, which is designed as a heat shield of a combustion chamber.

8. Product (1) according to Claim 6, which is designed as a turbine blade.

9. Product (1) according to Claim 8, which extends in cross section from a leading edge (7) to a trailing edge (8), and between these edges, on opposite sides, has a pressure side (9) and a suction side (10), the thermal barrier coating (5B) on the suction side (10) and the pressure side (9) having substantially the same fine structure and on the leading edge (7) having a finer fine structure.

10. Product (1) according to one of the preceding claims, in which the thermal barrier coating (5A, 5B) contains zirconium oxide (ZrO₂) or a compound selected from the group of the refractory perovskites or the spinels.

11. Product (1) according to Claim 11, in which the thermal barrier coating (5A, 5B) is partially or completely stabilized with yttrium oxide (Y₂O₃) or another oxide of the rare earths.

12. Product (1) according to one of the preceding claims, which has a metallic base body (2), in particular made from a nickel-base and/or cobalt-base alloy.

13. Product (1) according to one of the preceding claims, in which an adhesion promoter layer (11), in particular made from an alloy of the MCrAlY type, where Cr represents chromium, A1 represents aluminium, M represents one or more elements selected from the group consisting of iron, cobalt and nickel, and Y represents one or more elements from group IIIb of the periodic system including the actinides and the lanthanides and rhenium, is arranged between base body (2) and thermal barrier coating (5A, 5B).

14. Process for applying a thermal barrier coating (5A, 5B) to a product (1) which can be exposed to a hot aggressive gas (16) and has a base body (2), to which a thermal barrier coating (5A, 5B) of uniform chemical composition is applied in such a manner that, in a first surface region (3A), the thermal barrier coating (5A) is formed with a first fine structure and in a second surface region (3B) the thermal barrier coating (5B) is formed with a second fine structure, in accordance with the locally expected thermomechanical loading when the product (1) is in use.

15. Process according to Claim 14, in which the product (1) used is a blade of a turbomachine which has a suction side (10) and a pressure side (9), the thermal barrier coating (5B) on the suction side (10) having the same fine structure as on the pressure side (9).

16. Process according to Claim 14 or 15, in which the product (1) used is a blade of a turbomachine having a leading edge (7) and, adjoining this edge, a suction side (10) and pressure side (9), a thermal barrier coating (5A) with a finer fine structure than a thermal barrier coating (5B) on the suction side (10) and/or pressure side (9) being applied to the leading edge (7).

17. Process according to Claim 14 to 16, which is carried out as an electron beam sputtering process (EB-PVD) or a reactive gas flow sputtering process.

18. Process according to Claim 17, in which process parameters, such as the relative movement between product (1) and a particle jet (35) which forms the thermal barrier coating (5A, 5B), coating rate, overall pressure in a coating chamber, partial pressure of a reactive gas, temperature of the product (1), are controlled according to the fine structure of the thermal barrier coatings (5A, 5B) which is to be achieved.

## Revendications

1. Produit (1) qui peut être exposé à un gaz chaud corrosif (16), comportant un corps de base (2) sur lequel est appliquée une couche thermo-isolante (5A, 5B) de composition chimique commune, qui a dans une première zone de surface (3A) une structure fine autre que dans une deuxième zone de surface (3B).

2. Produit (1) selon la revendication 1, pour lequel la couche thermo-isolante (5A, 5B) présente une structure fine comportant des tiges céramiques (6) qui sont orientées pratiquement normalement à la surface (4) du corps de base (2).

3. Produit (1) selon la revendication 2, pour lequel les tiges céramiques (6) ont un diamètre (D1 ) moyen plus petit dans une première zone de surface (3A) que dans une deuxième zone de surface (3B).

4. Produit (1) selon l'une des revendications 1 à 3, pour lequel la couche thermo-isolante (5A) a une structure fine plus fine dans la première zone de surface (3A) que dans la deuxième zone de surface (3B).

5. Produit (1) selon l'une des revendications précédentes, pour lequel la couche thermo-isolante (5A) a une structure fine plus dense dans la première zone de surface (3A) que dans la deuxième zone de surface (3B).

6. Produit (1) selon l'une des revendications précédentes qui est conformé en tant qu'élément d'une machine thermique, en particulier d'une turbine à gaz.

7. Produit (1) selon la revendication 6 qui est conformé en tant que bouclier thermique de la chambre de combustion.

8. Produit (1) selon la revendication 6 qui est conformé en tant qu'aube de turbine.

9. Produit (1) selon la revendication 8 qui en section transversale s'étend depuis un bord d'attaque du courant (7) jusqu'à un bord de fuite du courant (8) et qui présente entre celles-ci un intrados (9) et un extrados (10) qui se font face, la couche thermo-isolante (5B) présentant sur l' extrados (10) et sur l'intrados (9) pratiquement la même structure fine et une structure fine plus fine sur le bord d'attaque du courant (7).

10. Produit (1) selon l'une des revendications précédentes, pour lequel la couche thermo-isolante (5A, 5B) comprend de l'oxyde de zirconium (ZrO₂) ou un composé choisi dans le groupe des perovskites réfractaires ou des spinelles.

11. Produit (1) selon la revendication 10, pour lequel la couche thermo-isolante (5A, 5B) est partiellement ou intégralement stabilisée à l'aide d'oxyde d'yttrium (Y₂O₃) ou d'un autre oxyde des terres rares.

12. Produit (1) selon l'une des revendications précédentes qui présente un corps de base (2) métallique, en particulier en un alliage à base de nickel et/ou de cobalt.

13. Produit (1) selon l'une des revendications précédentes, pour lequel il est placé entre le corps de base (2) et la couche thermo-isolante (5A, 5B) une couche d'agent adhésif (11), en particulier en un alliage du type MCrAlY, où Cr représente le chrome, Al l'aluminium, M un élément ou plusieurs éléments du groupe qui comprend le fer, le cobalt et le nickel, et où Y est un élément ou plusieurs éléments du groupe III b du système périodique, y compris les actinides et les lanthanides ainsi que le rhénium.

14. Procédé pour appliquer une couche thermo-isolante (5A, 5B) sur un produit (1) qui peut être exposé à un gaz chaud (16) corrosif et qui présente un corps de base (2) sur lequel on applique une couche thermo-isolante (5A, 5B) de composition chimique commune de telle manière que la couche thermo-isolante (5A) se forme dans une première zone de surface (3A) comportant une première structure fine et la couche thermo-isolante (5B) se forme dans une deuxième zone de surface (3B) comportant une deuxième structure fine en fonction de la contrainte thermomécanique escomptée localement lors de l'emploi du produit (1).

15. Procédé selon la revendication 14, pour lequel on utilise en tant que produit (1) une aube d'une turbomachine avec un extrados (10) et avec un intrados (9), la couche thermo-isolante (5B) présentant la même structure fine sur l' extrados (10) que sur l' intrados (9)

16. Procédé selon la revendication 14 ou 15, pour lequel on utilise en tant que produit (1) une aube d'une turbomachine comportant un bord d'attaque du courant (7) et un extrados (10) qui s'y raccorde et un intrados (9),; on applique alors sur le bord d'attaque du courant (7) une couche thermo-isolante (5A) comportant une structure fine plus fine qu'une couche thermo-isolante (5B) sur l'extrados (10) et/ou sur l'intrados (9).

17. Procédé selon la revendication 14 à 16 qui est réalisé en tant que procédé de pulvérisation à faisceau d'électrons (EB-PVD) ou en tant que procédé réactif de pulvérisation à courant gazeux.

18. Procédé selon la revendication 17, pour lequel, en fonction de la structure fine à obtenir des couches thermo-isolantes (5A, 5B), on commande des paramètres opératoires comme le mouvement relatif entre le produit (1) et un faisceau de particules (35) qui forme la couche thermo-isolante (5A, 5B), le taux de recouvrement, la pression totale dans une chambre de revêtement, la pression partielle d'un gaz réactif, la température du produit (1).
